Europäisches Patentamt

European Patent Office

Office européen des brevets

(11) Publication number: **0 260 943**
**A2**

# (12) EUROPEAN PATENT APPLICATION

(21) Application number: **87308182.2**

(22) Date of filing: **16.09.87**

(51) Int. Cl.⁴: **G 03 F 7/10**
**G 03 C 1/68**

(30) Priority: **18.09.86 US 908567**

(43) Date of publication of application:
**23.03.88 Bulletin 88/12**

(84) Designated Contracting States:
**AT BE CH DE ES FR GB GR IT LI LU NL SE**

(71) Applicant: **NAPP SYSTEMS (USA) INC.**
**360 South Pacific Avenue**
**San Marcos California 92069 (US)**

(72) Inventor: **Arimatsu, Seiki**
**3612, Cresta Court**
**Oceanside California 92056 (US)**

**Sakurai, Kiyomi**
**246 Emerald Drive No. 402**
**Vista California 92083 (US)**

(74) Representative: **Votier, Sidney David et al**
**CARPMAELS & RANSFORD 43, Bloomsbury Square**
**London WC1A 2RA (GB)**

(54) Photopolymer printing plate with matte surface.

(57) A photopolymer printing plate suitable for letterpress printing is described in which the photosensitive surface of the plate includes as an intimate part thereof, particulate material, which remains after processing to provide a matte surface for the plate. The particulate material may be silica, alumina, zinc oxide, talc, calcium carbonate, corn starch, or a resin compound and is applied as a dispersion of the particulate material in a suitable solvent. The dispersion, optionally, may include a binder, dyes and surfactants.

EP 0 260 943 A2

## Description

### "PHOTOPOLYMER PRINTING PLATE WITH MATTE SURFACE"

Field of the Invention

This invention relates to photopolymer printing plates, and more particularly, to photopolymer printing plates for letterpress printing having a matte surface of particulate material deposited on and consolidated with the photosensitive surface.

Background of the Invention

Photopolymerizable compositions suitable for producing photopolymer printing plates are well-known in the art. In United States Patent 3,801,328, the disclosure of which is incorporated herein by reference, photopolymerizable composition is described, which has met with significant commercial success and has been found to be particularly satisfactory for the production of letterpress printing plates.

In the use of letterpress printing plates, it is necessary to expose the plate to an ultraviolet light source through a negative film. When a negative film is placed on a smooth photopolymer surface, however, it does not contact the surface at all points, due to air entrapment in the form of pockets and to the sticking characteristics of the photopolymer against the negative film. Accordingly, when a photopolymer plate has been exposed under such conditions and is thereafter processed, the resulting plate will have small irregularly shaped elevations, randomly located on the surface of the solid area. These areas are commonly referred to in the art as "mesas". (W.J. McGraw, TAGA Proceedings, 1965, pp. 34-48.)

If mesas exist on the surface of the photopolymer plate, irregular non-printing areas will be produced within the printed piece corresponding to the area within the mesa outline, due to the inability of the ink rollers to make intimate contact at the base of the abrupt elevation. To prevent this condition. a number of operational procedures have been used.

For a liquid type photopolymer systems, a thin air gap is maintained between the negative film and photosensitive liquid layer or a thin transparent plastic film is placed between the negative film and photosenstivie liquid layer. Both of these procedures are complicated and need sophisticated machines for successful implementation. For solid type photopolymer systems, powdering materials like baby powder or talc have been used, as has a negative film with a matte surface on its contacting surface. In the powdering procedure, it is very difficult to achieve a uniform coating, and the fine dispersion of powder in the form of airborne dust can be a nuisance factor. Therefore, the use of a negative film with a matte surface is the most common procedure for a solid type photopolymer system. This results, however, in the ability to utilize the photopolymer plate successfully only with negative films having such a matte surface. This in turn restricts the use of the photopolymer plates, and it is therefore highly desirable to have a photopolymer plate that is compatible with negative films having either a smooth or matte surface.

There is a second problem relating to the surface characteristics of the photopolymer plate; since the processed photopolymer plate generally has a smooth surface and therefore poor ink retention on the surface (good ink transfer as a result), the inking amount on the plate should be reduced to prevent fattening of image and the spread of ink, which results in poor solid density. If the processed plate has a roughened or textured surface, the inking amount can be increased to get a higher solid density without having printing defects like fattening of image and spread of ink because of superior ink retention on the surface due to the surface roughness. Also, reproduction of middle tone to shadow areas will be improved by a roughened surface, because of the adjusted ink transfer characteristics. To accomplish this, it is necessary that the surface of the developed plate have roughened characteristics.

Description of Prior Art

Previously, the art has sought to address the problem of photopolymer plate compatibility with negative films by utilizing what are referred to as slip or matte layers which are applied to the photopolymer plate after formation.

Examples of such attempts are described in United States Patents 4,126,460 and 4,216,289, in British Patents 1,495,361 and 1,512,080, and in U.K. Patent Publication 2,075,702A. In each of these, however, the slip or matte surface layer must be removed after processing and the resulting photopolymer plate still suffers from the limitation of print quality discussed above.

Other examples are described in United States Patents 3,458,311 and 4,072,527, in which a solid, water-permeable, protective layer is used that is non-strippable as an unsupported film In each of these patents, however, the layer functions as an oxygen barrier in order to give high sensitivity. Such a layer has a tendency to cause a storage problem due to prohibited oxygen penetration into the polymer systems. Also, the layer preferably is removable by conventional developing solutions even if non-strippable characteristics are claimed. The patents do not describe nor suggest the need to retain the rough surface on the processed plate.

In United States Patent 4,469,775, a multilayer photopolymer printing plate is described, which contains as the outer layer a highly hydrolyzed (not less than 95 mole percent) low molecular weight polyvinyl alcohol that is intended to protect the plates against exposure to air during storage in which the properties of the plate deteriorate due to evaporation of monomer. Substances such as dyes or pigments can be included in the hydrolyzed polyvinyl alcohol layer to modify optical or mechanical properties as for example, abrasin resistance or roughness. However, the hydrolyzed polyvinyl alcohol layer is a separate and distinct layer from the photosensitive layer, and is not applied directly to the photosensitive surface as a dispersion, but is applied to a temporary base and thereafter transferred to the previously prepared photosensitive layer of the multilayer plate. The temporary base is then removed. Since a temporary support is used, the production method itself is very expensive. In addition, there is no recognition of the advantages of a rough surface after processing.

In United States Patent 3,891,443, matte finish photosensitive relief plates are suggested, which include a process for the photosensitive material to take the configuration of a grained or matte surface of another material like a grained metallic plate or a matte finish plastic film (e.g. polyester film) or paper which has a matte finish surface. This is said to give the advantages of a matte surface, with respect to uniform contact of a negative film to the photosensitive material and superior ink receptivity due to the numerous small depressions on the processed plate. This process, however, does not completely eliminate stickiness and the matte level changes during storage. When the material providing the matte surface is left together with the photopolymer plate in order to solve this problem, storage problems occur.

## SUMMARY OF THE INVENTION

In the present invention, a photopolymer printing plate is provided, wherein the photosensitive surface has particulate material consolidated therewith as an intimate part of the photopolymer layer which remains following developing. The particulate material is applied to the photosensitive surface as a dispersion of particulate material in a solvent.

The solvent which carries the dispersion of particulate material, may be water or an organic substance, which softens or dissolves the surface of the photosensitive layer such that the particulate material is disposed on and becomes consolidated with the surface of the photosensitive layer. The resulting photopolymer plate, with its roughened or matte surface, prevents sticking of the negative film to the plate surface during exposure and also retains the particles on the surface of the processed plate, thus providing a suitable roughness for an overall improvement in printing quality, that is, higher solid density and improved tone reproduction of middle tone to shadow area. It is also to be noted that the present invention is fully compatible with all negative films, as well as resulting in a distinct improvement in printing quality. Additionally, this invention does not decrease storage stability and is prepared by a straightforward inexpensive process.

## Detailed Description of the Invention

The photopolymer printing plate of the present invention comprises a dimensionally stable substrate and a photosensitive or photopolymer layer with particulate material on the surface. As noted above, the particulate material is applied to the photosensitive surface as a dispersion of particles in a solvent.

A number of dimensionally stable substrates or bases may be used in the present invention, including dimensionally stable materials conventionally used as bases for printing plates. Illustrative of such materials are metallic plates such as aluminum, steel or tin, and plastic substrates. Preferred substrates are aluminum and tin plates. The substrate may be treated chemically or physically prior to coating with the photopolymerizable material to insure adequate adhesion between the substrate and the photopolymerizable composition. Roughening or grading of the substrate surface may eliminate the need for a separate adhesive layer, although such a layer may also be utilized if desired.

The photopolymer or photosensitive surface may be any of a number of such surfaces known and utilized in the art. One of the preferred photopolymerizable materials are water-developable materials such as described in United States Patent 3,801,328. Thus, the photopolymerizable composition will include polymer and monomer components and a polymerization initiator. The polymer may be soluble in a solvent, compatible with the monomer system, and become insoluble in the solvent upon exposure to ultraviolet light. Suitable examples are polyamides (including copolymers), cellulose derivatives (ethyl cellulose acetate phthalate, ethyl cellulose, hydroxypropylmethyl cellulose, etc.) polyesters, polyvinyl alcohol, partially saponified polyvinyl acetate, polyethylene oxide, polyvinylpyrrolidone, and the like. For water-developable materials, the polymer may be a partially saponified polyvinyl acetate, preferably having an average degree of polymerzation of about 300 to about 2000 and a saponification degree of about 65 to approximately 99 mole percent, or a mixture of partially saponified polyvinyl acetates. As used here, saponification means the conversion of ester groups or the like into alcohol groups, and the degree of saponification represents the extent to which ester groups have been converted to alcohol or hydroxy groups.

The monomer component of the photopolymerizable material will include at least one ethylenically unsaturated monofunctional and/or polyfunctional monomers such as (meth)acrylic acid, (meth)acrylates, and (meth)acrylamides.

Suitable examples of monofunctional (meth)acrylates are:
2-ethylhexyl (meth)acrylate,
2-hydroxethyl (meth)acrylate,
2-hydroxypropyl (meth)acrylate, and
polyethyleneglycol (meth)acrylate.

Suitable examples of polyfunctional (meth)acrylates are:
ethyleneglycol di(meth)acrylate,

diethyleneglycol di(meth)acrylate,
tetraethyleneglycol di(meth)acrylate,
polyethyleneglycol di(meth)acrylate,
neopentylglycol di(meth)acrylate,
1,4-butanediol di(meth)acrylate,
1,6-hexanediol di(meth)acrylate,
1,6-hexanediol di(meth)acrylate,
pentaerythritol tri(meth)acrylate,
trimethylolpropane tri(meth)acrylate,
pentaerythritol tetra(meth)acrylate,
ditrimethylolpropane tetra(meth)acrylate,
dipentaerythritol penta or hexa(meth)acrylate,
and their exthoxylated or propoxylated derivatives.

Suitable examples of (meth)acrylamides are:
(meth)acrylamide,
N-methylol (meth)acrylamide,
methylene-bis-(meth)acrylamide, etc.

The photopolymerization initiator may be any of a number of such materials, such as acetophenone, benzophenone or benzoin derivatives thereof, and benzil and benzil compounds. Illustrative acetophenone derivatives include 2,2-diethoxyacetophenone, 2,2-dimethoxy-2-phenylacetophenone, 2,2-diethoxy-2-phenylacetophenone, and the like, while bezophenone derivatives suitable for use in the present invention include benzophenone, 2-methylbenzophenone, 2-methoxybenzophenone, and the like. Benzoin derivatives include methyl, ethyl, isopropyl, and n-butyl, ethers of benzoin, as for example, benzoinmethylether, benzoinethylether, benzoinisopropylether, benzoin-n-butylether, etc. Other initiators may also be utilized, such as benzil, 2-ethylanthraquinone, 1-hydroxy-cyclohexylphenylketone, and xanthones such xanthone, thioxanthone, 2-chlorothioxanthone, and 2-isopropylthioxanthone. The initiators may be used alone or in combination with one another.

The photopolymerizable composition may also include a thermal polymerization inhibitor such as phenol derivatives, as for example, p-methoxyphenol, hydroquinone derivatives, benzoquinone derivatives, 2,6-di-t-butyl-p-cresol, and nitroso compounds.

The composition will typically include from about 20 to about 95 percent by weight, based on the total weight of the photopolymer composition, of at least one of the indicated polymer components and from about 20 to about 95 weight percent of the monomer components. The photopolymerization initiator will typically by used in a quantity of from about 0.001 weight percent to about 10 weight percent, preferably from about 0.1 to about 7 weight percent. If a thermal inhibitor is utilized, it will ordinarily be present in a quantity from about 0.001 percent to about 1.0 percent, preferably from about 0.005 to about 0.5 weight percent, based on the total weight of the photopolymerizable composition. In parts by weight, a typical or representative photopolymer composition will contain from about 0.1 to about 3.0 parts by weight of polymer, about 0.1 to about 3.0 parts by weight of monomer component, about 0.001 to about 0.3 parts by weight of polymerization initiator and fromn about 0.0001 to about 0.3 parts by weight thermal inhibitor.

The photopolymer composition is formed in the manner known by those skilled in the art, such as described in U.S. Patent 3,801,328. Thus, for example, where the polymer component is a partially saponified polyvinyl acetate, a mixture of the partially saponified polyvinyl acetate and water is prepared and kneaded at a temperature of about 90 to 95°C for approximately one-half hour. After kneading, the temperature is lowered to approximately 60°C, and a mixture of monomers and photopolymerization initiator is added to the PVA-water mixture. If a thermal inhibitor is utilized, it will be included in the monomer-initiator mixture. The monomer-initiator-inhibitor components may thus be added to the PVA-water mixture over a period of approximately one-half hour, after which the photopolymerizable composition will be cast on to the dimensionally stable substrate. The photocopolymerizable or photosensitive surface layer will have a thickness within the range of about 0.010 inches to about 0.050 inches, perferably about 0.015 to about 0.040 inches, after volatile materials are eliminated.

The particulate material is a non-reactive material which is insoluble in the ingredients of the photosensitive layer or the solvent which is used to develop the photosensitive layer, and preferably, is silica, alumina, zinc oxide, talc, calcium carbonate, corn starch, or a resin compound. The average particle size of the particulate material will be from about 0.5 microns to about 40 microns, preferably about 1 to about 20 microns. The particulate material is disposed on the photopolymer surface typically as a dispersion of the particulate material in an appropriate solvent. The particulate dispersion may also include a polymeric binder, dyes and surfactants. The binder will adjust the viscosity of the dispersion and aid the particulate material in binding to the surface of the photopolymer layer and, therefore, preferably will be the same binder utilized in the photopolymer layer or have good compatability with the soluble polymer in the photosensitive layer. For example, if partially saponified polyvinyl acetate (80% hydrolysis, polymerization degree:500) is the soluble polymer in the photosensitive layer, the same type of partially saponified polyvinyl acetate (80% hydrolysis, polymerization degree:500) can be used for an organic binder of the dispersion. Different types of partially saponified polyvinyl acetate may also be used (75% hydrolysis or 88% hydrolysis or 99% hydrolysis, polymerization degree:300, 500, 1700, etc.), cellulose derivatives (hydroxyethyl cellulose, hydroxypropylmethyl

4

cellulose, etc.), polyethylene oxide, etc. which are compatible with the soluble polymer in the photosensitive layer may also be used. If alcohol soluble polyamide is the soluble polymer in the photosensitive layer, alcohol soluble polyamide itself may be used for an organic binder of the dispersion as well as polyvinylpyrro lidone and the like which are compatible with the soluble polymer in the photosensitive layer. A dye can be used to adjust the sensitivity of the polymer layer at the surface, while a surfactant may be used to obtain a stable dispersion of the particulate material in the solvent.

Particulate materials can be dispersed in the selected solvent in any concentration, based on the method of application. If an organic binder, dye, and surfactant are to be added, the following should be considered. The ratio of the volume of organic binder to the volume of particulate materials should be less than one. If it is more than one, a continuous layer of organic binder will be formed, thus preventing oxygen penetration into the photosensitive layer and resulting in premature polymerization and inadequate subsequent development. The ratio of the weight of dye to the weight of particulate materials and organic binder should be less than 0.01, preferably 0.0005. If the ratio is larger, the sensitivity of the original photosensitive layer will be lowered. The ratio of the weight of surfactant to the weight of particles and an organic binder should be less than one, preferably 0.5. If it is larger, the surface will be wet, especially in case of liquid surfactants.

The dispersion of particulate material in the solvent may be applied by spraying the dispersion onto the surface of the photopolymer layer, although it may also be applied by other conventional methods such roll coating or gravure coating. The surface of the photosensitive layer on which the dispersion is applied may be wet, partially dried, or completely dried. The application weight of the dispersion is in the range of from about 0.05 to about 3 grams per square meter, on a dry basis, of the surface area of the photosensitive layer, and preferable from about 0.05 to about 1 gram per square meter. It has been found that if the dispersion is applied in a lesser quantity, the negative film exhibits surface thickness when brought into intimate contact with the photopolymer layter. If the quantity exceeds this range, on the other hand, the resulting printing quality will be degraded, because of reduced shadow and reverse line depth, due to excess light scattering caused by the particulate material.

When the dispersion of particulate materials is applied to the surface of the photopolymer layer, the solvent softens or dissolves the surface of the photopolymer layer and the particulate material becomes fixed or consolidated with the surface of the photopolymer layer as an intimate part thereof rather, than as a separate layer. By drying, the solvent vaporizes and the particulate material is fixed to and physically consolidated with and retained on the surface. It has been found, utilizing such photopolymer printing plate with the described matte surface, that sticking of the photopolymer surface to the negative film is avoided during exposure to ultraviolet light and that the particles on the surface of the processed plate provide better printing quality with improved tone reproduction at the middle tone to shadow area. It has additionally been found that shorter exposure times may be used to hold fine line and highlight (fine dots) because of light scattering, and also that increased depth of shadow areas and reversed lines is achieved because of the shorter exposure time and inhibition of surface polymerization by air (oxygen). This may also help the improved tone production.

The invention will be better understood by reference to the following specific, but illustrate examples. The amounts and percentages in the compositions are all by weight, unless otherwise indicated.

Example 1

(1) Preparation of Photopolymer Plate

Partially saponified polyvinyl acetate (hydrolysis 80%, polymerization degree:500) (70 parts), partially saponified polyvinyl acetate (hydrolysis 88%, polymerization degree:500) (30 parts) and water (80 parts) are introduced into a kneader, and the resulting mixture is kneaded at 90 to 95°C for half an hour. After the mixing is completed, the temperature within the kneader is lowered to 60°C. To this mixture, there is added dropwise a mixture of p-methoxyphenol (p.2 part), benzil dimethylketal (2.5 parts), diethyleneglycol dimethacrylate (8 parts), and 2-hydroxyethyl methacrylate (100 parts) over a period of 40 minutes. A solution of rose bengal (0.025 part) in water (1 part) is added thereto. After the mixing is completed, the resulted mixture is defoamed under reduced pressure to give a photopolymerizable composition having a good adhesion to metal plates.

The thus prepared photopolymerizable composition is cast on a metal plate, and a polyester film is placed thereon. The resulting product is passed between a pair of rollers to provide a resin composition thickness of about 30 mils.

After cooling, the polymer film is peeled off, and the plate is dried in a dryer at 80°C for about 30 minutes to give a photopolymer plate. (Roughness: Rmax:0.2, Rz=0.1 μ.)

(2) Preparation of the Particulate Dispersion

Cornstarch (average particle size: 15 μ) (5 parts) is dispersed in water (100 parts) at 300 RPM is half an hour.

(3) Application of the Dispersion to the Photopolymer Plate

The dispersion of cornstarch in water is sprayed onto the photopolymerplate prepared as set forth above. The uniformly sprayed amount is about 3g for 14 inch x 24 inch size. The sprayed plate is dried in an oven at 80°C for about 1 minute to give a photopolymer plate with a matte surface. (Roughness: Rmax:4.0 μ, Rz=2.8 μ.)

(4) Comparison of Exposure Condition and Image Quality Between Smooth Photopolymer Plate and Matted Photopolymer Plate

The photopolymer plate with smooth surface prepared according to (1) above and the photopolymer plate with matte surface prepared according to (3) are exposed to UV light, using a 3KW high pressure mercury lamp through test negative film. The exposure time required to hold 2% high light dot and 50 $\mu$ fine line, and the resulting image quality are listed below.

| Plate | Exposure Time (Pre-Exposure x Main Exp.) | Depth of 90% Shadow | Depth of 100 $\mu$ Reverse Line | Roughness The Processed Plate. |
|---|---|---|---|---|
| (1) Smooth | 3 x 45 sec. | 25 | 28 | Rmax:0.2 $\mu$ Rz:0.1 $\mu$ |
| (2) Matte | 3 x 40 sec. | 35 | 40 | Rmax:3.6 $\mu$ Rz:2.8 $\mu$ |

(5) Printing Test

A printing test was carried out using an actual newspaper press to compare the image quality of the two plates. Smoother solid ink laydown, improved highlight retention, and improved mid-tone/shadow detail are observed with the matted plate.

Example 2

The procedure set forth in Example 1 is repeated except that the wet plate is dried for about 15 minutes (still wet) and sprayed, then dried again for about 15 minutes. Rougness is; Rmax:3.5 $\mu$, Rz=2.0 $\mu$.

The print test clearly demonstrates an improved solid smoothness compared with plain surface plate.

Example 3

The procedure set forth in Example 1 is repeated except that the wet plate is sprayed before drying, then dried for about 30 minutes. Roughenss is; Rmax:3.2 $\mu$, Rz=1.9 $\mu$.

Example 4

The procedure set forth in Example 1 is repeated, except that 1 part of synthetic silica (average particle size:6 $\mu$) is used instead of 5 parts of cornstarch, and 0.5 part of ethoxylated nonylphenol type surfactant was added to the dispersion of (2). Roughness is; Rmax:3.6 $\mu$, Rz=2.1 $\mu$.

Example 5

The procedure set forth in Example 1 was repeated except that the particulate dispersion was prepared as follows and the application of the dispersion to the photopolymerplate was by gravure coating; partially saponified polyvinyl acetate (88% hydrolysis, polymerization degree:500) (8 parts), 0.5% aq. solution of eosin dye (5 parts), and water (100 parts) are mixed and dissolved. Then, cornstarch (average particle size = 15 $\mu$) (10 parts) is dispersed in the above solution. Coating weight (wet) is about 1.5 g for 14 inch x 24 inches size. Roughness is; Rmax:3.5 $\mu$, Rz=2.2 $\mu$.

The results obtained in printing with a newspaper press demonstrates the improved solid smoothness and overall image quality of Examples 3, 4 and 5.

Example 6

A copolymer of vinylpyrrolidone and vinyl acetate (available as 50% ethanol solution from GAF; E-535) (100 parts) is mixed with the mixture of diethyleneglycol dimethacrylate (15 parts), benzoin isopropyl ether (2 parts), and 2,b-di-t-butyl-p-cresol (0.2 part). After the mixture is completed, the resulting mixture is defoamed by sitting overnight.

The thus prepared photopolymerizable composition is cast on a metal plate and thickness is adjusted to be about 40 mils. The resulting plate is dried in an oven at 60°C for about 60 minutes to give a photopolymer plate.

A dispersion of synthetic silica (average particle size: 9 $\mu$) (5 parts) in ethanol (100 parts) is uniformly sprayed on the photopolymer plate (about 3g for 14 inch x 24 inch size) and dried for one minute at 80°C. Roughness is; Rmax:3.3 $\mu$, Rz-2.0 $\mu$.

In a newspaper printing test, the quality of the image showed the superior characteristics reported for Examples 1 through 5.

**0 260 943**

## Claims

1. A photopolymer printing plate suitable for relief printing comprising a dimensionally stable substrate with a photopolymer layer thereon, said photopolymer layer including a non-reactive particulate material intimately consolidated therewith to provide a matte surface for said plate, said particulate material being incapable of dissolving in said photopolymer layer or the solvent for developing said photopolymer layer and having an average particle size of about 0.5 to about 40 microns and being present in an amount of from about 0.05 to about 3 gram per square meter of surface.

2. The photopolymer printing plate of claim 1 in which said particular material is selected from the group consisting of silica, alumina, zinc oxide, talc, calcium carbonate, cornstarch, and a resin compound.

3. The photopolymer printing plate of claim 1 in which said particulate material is deposited on said photopolymer layer by coating on said photopolymer layer a dispersion of particulate material in a solvent capable of softening or dissolving the surface of said photosensitive layers.

4. The photopolymer printing plate of claim 3 in which said dispersion of particulate material includes an organic binder.

5. The photopolymer printing plate of claim 4 in which said solvent is water and said binder is a water soluble polymer binder of partially saponified polyvinyl acetate.

6. The photopolymer printing plate of claim 1, 2, or 3, in which said photopolymer layer comprises ethylenically unsaturated monomers, a soluble polymer compatible with said monomer components, and a polymerization initiator activatable by actinic light.

7. A photopolymer printing plate for letterpress printing comprising a dimensionally stable substrate with a water developable photopolymer layer thereon, said photopolymer layer comprising at least one ethylenically unsaturated monomer, a partially saponified polyvinyl acetate, and a polymerization initiator activatable by actinic light and including a non-reactive particulate material intimately consolidated therewith to provide a matte surface for said plate, said particulate material being incapable of dissolving in said photopolymer layer or the solvent for developing said photopolymer layer and having an average particulate size of about 0.5 to about 40 microns and being present in an amount of from about 0.05 to about 3 grams per square meter of surface.

8. The photopolymer printing plate of claim 7 in which said substrate is a metallic plate and said photopolymer layer comprises at least one monofunctional and one polyfunctional monomer, said partially saponified polyvinyl acetate has an average degree of polymerization of about 300 to about 2000 and a saponification degree of about 65 to about 99 mole percent, and said polymerization initiator is acetophenone, benzophenone or benzoin or a derivative thereof, benzil or a benzil compound.

9. The photopolymer printing plate of claim 7 or 8 in which said particulate material has an average particle size of about 1 to about 20 microns and is present in an amount of about 0.05 to abut 1 gram persquare meter of surface.

10. The photopolymer printing plate of claim 7, 8 or 9 in which said particulate material is silica, zinc oxide, alumina, talc, calcium carbonate, cornstarch or a resin compound.

11. The photopolymer printing plate of claim 10 said particulate material is deposited on said photopolymer layer by coating on said photopolymer layer a dispersion of particulate material in a solvent capable of softening or dissolving the surface of said photosensitive layer.

12. The photopolymer printing plate of claim 11 in which said dispersion of particulate material includes an organic binder.

13. The photopolymer printing plate of claim 12 in which said solvent is water and said binder is a water soluble polymer polymer binder of partially saponified polyvinyl acetate.